# EUROPEAN PATENT SPECIFICATION

(11) **EP 3 007 531 B1**
(45) Date of publication and mention of the grant of the patent: **24.10.2018**
(21) Application number: 14874601.9
(22) Date of filing: 08.07.2014
(51) Int. Cl.: H01L 23/373, H01L 21/48, B32B 37/06, B32B 37/10, F28F 21/02, F28F 21/08, H01L 23/42

(54) **HEAT CONDUCTIVE COMPOSITE MATERIAL SHEET AND FABRICATION METHOD THEREOF**
WÄRMELEITENDES VERBUNDMATERIALBLECH UND HERSTELLUNGSVERFAHREN DAFÜR
FEUILLE THERMO-CONDUCTRICE DE MATÉRIAU COMPOSITE ET SON PROCÉDÉ DE FABRICATION

(30) Priority: 27.12.2013 CN 201310738145
(43) Date of publication of application: 13.04.2016
(73) Proprietor: Huawei Technologies Co., Ltd., Longgang District Shenzhen, Guangdong 518129 (CN)
(72) Inventor: HU, Rui, Xi'an Shaanxi 710072 (CN); ZHAI, Liqian, Shenzhen Guangdong 518129 (CN); WANG, Dong, Shenzhen Guangdong 518129 (CN); CHI, Shanjiu, Shenzhen Guangdong 518129 (CN); LI, Jinshan, Xi'an Shaanxi 710072 (CN); SUN, Zhigang, Xi'an Shaanxi 710072 (CN)
(74) Representative: Isarpatent
(86) International application number: PCT/CN2014/081785
(87) International publication number: WO 2015/096453

(56) References cited:
- EP-A2- 1 993 135
- EP-A2- 2 012 355
- CN-A- 101 160 033
- CN-A- 101 994 071
- CN-A- 102 586 703
- CN-A- 103 343 265
- JP-A- 2013 214 576
- TW-A- 200 829 102

## Description

### TECHNICAL FIELD

The present invention relates to the field of thermal control technologies, and in particular, to a thermally conductive composite sheet with high thermal conductivity and a method for making same.

### BACKGROUND

In heat dissipation structures of electronic parts and components, forged aluminum alloy materials with relatively high strength and a relatively high heat conductivity, for example, 6XXX series (6061 and 6063) aluminum alloys of America types and LD series aluminum alloys of China types, are usually applied to structures such as heat dissipation fins and heat sink frameworks. The 6XXX series aluminum alloys are a type of medium- and high-strength aluminum alloys that can be strengthened by means of heat treatment, and have a series of excellent comprehensive properties such as desirable manufacturability and corrosion resistance, sufficient toughness, capability of being colored by means of anodic oxidation, and no tendency of stress corrosion cracking. In addition, owing to characteristics such as high specific strength and a desirable heat-conducting property, the 6XXX series aluminum alloys can be used to prepare multiple types of purpose-specific structural or functional aluminum alloy members, and are widely applied in fields such as aviation and aerospace, transportation, electronics industry, architectural decoration, and sports equipment.

A highly thermally conductive graphite sheet is a novel highly thermally conductive heat dissipation material. At the end of the last century and the beginning of the current century, America and Japan have developed a highly thermally conductive pitch-based graphite material and developed products such as a cold-pressed highly thermally conductive graphite sheet, a highly thermally conductive pitch-based graphite fiber, and a highly thermally conductive mesophase pitch graphite foam, and the heat conductivity has increased from 1000 W/m.K to 1500 W/m.K. Especially, the cold-pressed highly thermally conductive graphite sheet has been applied to a packaging cover plate of an electronic component. Owing to having an even heat-conducting property along a direction perpendicular to a normal of a graphite sheet plane, the highly thermally conductive graphite sheet can improve performance of an electronic component (assembly) while increasing heat dissipation efficiency. Moreover, the highly thermally conductive graphite sheet is not aged or embrittled, and therefore is applicable to most chemical media. Currently, the highly thermally conductive graphite sheet has been widely applied to thermally conductive and heat dissipation components such as large-scale integrated circuits, high power density electronic parts, computers, 3G smartphones, and cutting edge electronic instruments, and also has a promising market prospect in fields of aerospace, aviation, computers, medical care, the communications industry, and electronics industry.

Compatibility between aluminum and graphite is poor, which is reflected in two aspects: first, liquid aluminum and graphite have poor wettability, and molten metal aluminum cannot be laid on a graphite substrate; and secondly, when a synthesis temperature exceeds 500°C, a chemical reaction occurs between aluminum and carbon, and a brittle carbide reaction layer is generated. As the synthesis temperature further increases, the chemical reaction becomes more serious, thereby seriously weakening a heat-conducting property of graphite itself and also causing degeneration of performance of a composite material.

Traditional hot pressing may be used to manufacture a high-performance material. However, for a material such as a pure nitride, carbide, oxide, or a bride with a theoretical density close to 100%, especially when highly thermally conductive ceramic or diamond, graphite, or the like with a high volume fraction needs to be mixed and combined with a metal matrix, it is difficult to perform preparation by using a powder sintering densification or liquid phase treatment technology. Moreover, a production capacity achieved by using this technology is quite limited, a heat treatment temperature reaches up to 2200°C, a cycle is generally 6 hours or 12 hours, a production process is complex, and a production cycle is long.

Document EP 1 993 135 A2 discloses a heat conductor with a first heat conductive region and a second heat conductive region. The first heat conductive region is configured by lamination of a first metal member and a graphite member. The second heat conductive region is configured by lamination of the first metal member and a second metal member

In document EP 2 012 355 A2 a heat dissipation plate having a lamination of a copper layer, a molybdenum layer and a graphite layer, and outer copper layers each provided on a surface of the lamination, is disclosed.

Document CN 102 586 703 A discloses a method for preparing a graphite whisker reinforced aluminum matrix composite material. The composite material consists of plated high-reinforced-phase heat conducting graphite whiskers and matrix aluminum or aluminum alloy. The production process comprises the steps of 1 adopting a chemical plating or vacuum salt bath plating method to plate copper or titanium on the surfaces of the graphite whiskers.

Document TW 200 829 102 A discloses a manufacturing method of aluminum alloy circuit plate.

Document JP 2013 214 576 A discloses a substrate for a power module with a heat sink, which includes a substrate for power module having a circuit layer placed on one surface of an insulation layer, and a heat sink bonded to the other surface of the substrate for power module.

### SUMMARY

A technical problem to be resolved in embodiments of the present invention is to provide a thermally conductive composite sheet and a method for making same, which can bond an aluminum alloy and graphite that are highly thermally conductive, and features relatively low production costs.

To achieve the foregoing objective, implementation manners of the present invention provide the following technical solutions:
According to a first aspect, a thermally conductive composite sheet is provided, where the thermally conductive composite sheet includes a first aluminum alloy layer, at least one graphite sheet, an aluminum alloy frame, and a second aluminum alloy layer, where the aluminum alloy frame is provided with at least one opening; the graphite sheet is positioned inside the opening of the aluminum alloy frame; the aluminum alloy frame and the graphite sheet are sandwiched between the first aluminum alloy layer and the second aluminum alloy layer; the first aluminum alloy layer is diffusion-bonded to the graphite sheet and the aluminum alloy frame; the second aluminum alloy layer is diffusion-bonded to the graphite sheet and the aluminum alloy frame; and the graphite sheet is cladded by the first aluminum alloy layer, the second aluminum alloy layer, and the aluminum alloy frame, to form a unity, wherein a thickness of the first aluminum alloy layer is 0.26 millimeters to 1.0 millimeters, and a thickness of the second aluminum alloy layer is 0.26 millimeters to 1.0 millimeters.

In a further possible implementation manner of the first aspect, materials of the first aluminum alloy layer, the second aluminum alloy layer, and the aluminum alloy frame are the same.

In a further possible implementation manner of the first aspect, there is one opening inside the aluminum alloy frame, there is also one graphite sheet, and the graphite sheet is accommodated inside the opening.

In a further possible implementation manner of the first aspect, there are multiple openings inside the aluminum alloy frame, there are also multiple graphite sheets, and each graphite sheet is correspondingly accommodated inside one opening.

According to a second aspect, a thermally conductive composite sheet is provided, where the thermally conductive composite sheet includes a first aluminum alloy layer, at least one graphite sheet, a first transition layer, a second transition layer, an aluminum alloy frame, and a second aluminum alloy layer, where the aluminum alloy frame is provided with at least one opening; the graphite sheet is positioned inside the opening of the aluminum alloy frame; the aluminum alloy frame and the graphite sheet are sandwiched between the first aluminum alloy layer and the second aluminum alloy layer; the first transition layer is disposed between the graphite sheet and the first aluminum alloy layer; the second transition layer is disposed between the second aluminum alloy layer and the graphite sheet; the first aluminum alloy layer and the first transition layer are diffusion-bonded; the first transition layer and the graphite sheet are diffusion-bonded; the graphite sheet and the second transition layer are diffusion-bonded; the second transition layer and the second aluminum alloy layer are diffusion-bonded; and two opposite sides of the aluminum alloy frame are separately diffusion-bonded to the first aluminum alloy layer and the second aluminum alloy layer, so that the first transition layer, the second transition layer, and the graphite sheet are cladded by the first aluminum alloy layer, the second aluminum alloy layer, and the aluminum alloy frame, to form a unity, wherein a thickness of the first aluminum alloy layer is 0.26 millimeters to 1.0 millimeters, and a thickness of the second aluminum alloy layer is 0.26 millimeters to 1.0 millimeters.

In a further possible implementation manner of the second aspect, materials of the first aluminum alloy layer, the second aluminum alloy layer, and the aluminum alloy frame are the same.

In a further possible implementation manner of the second aspect, there is one opening inside the aluminum alloy frame, there is also one graphite sheet, and the graphite sheet is accommodated inside the opening.

In a further possible implementation manner of the second aspect, there are multiple openings inside the aluminum alloy frame, there are also multiple graphite sheets, and each graphite sheet is correspondingly accommodated inside one opening.

In a further possible implementation manner of the second aspect, the first transition layer is made of titanium or an alloy including titanium.

In a further possible implementation manner of the second aspect, the second transition layer is made of titanium or an alloy including titanium.

In an further possible implementation manner of the second aspect, a thickness of the first transition layer is 20 micrometers to 40 micrometers.

In a further possible implementation manner of the second aspect, a thickness of the second transition layer is 20 micrometers to 40 micrometers.

According to a third aspect, a method for making a thermally conductive composite sheet is provided, where the method for making a thermally conductive composite sheet includes the following steps: providing two aluminum alloy sheets with a thickness of 0.26 millimeters to 1.0 millimeters and one aluminum alloy frame, where the aluminum alloy frame is provided with at least one opening, and performing mechanical treatment and chemical treatment on the aluminum alloy sheets and the aluminum alloy frame, so as to decrease roughness of surfaces of the aluminum alloy sheets and a surface of the aluminum alloy frame, and obtain active aluminum alloy surfaces; providing at least one graphite sheet; placing the graphite sheet inside the opening of the aluminum alloy frame, separately placing the aluminum alloy sheets on two opposite sides of the aluminum alloy frame and the graphite sheet to form a laminated structure, placing the laminated structure inside a furnace chamber, and vacuumizing the furnace chamber; and heating and pressurizing the laminated structure, and performing diffusion-bonding between the aluminum alloy frame in which the graphite sheet is placed and the two aluminum alloy sheets, so as to obtain a thermally conductive composite sheet.

In a first possible implementation manner of the third aspect, the mechanical treatment includes grinding and polishing, so as to decrease roughness of the surfaces of the aluminum alloy sheets and an aluminum alloy surface.

In a second possible implementation manner of the third aspect, the chemical treatment includes acid cleaning and alkaline cleaning, so as to obtain the active aluminum alloy surfaces.

In a third possible implementation manner of the third aspect, the furnace chamber is vacuumized until an intensity of pressure is 5×10-3 Pa to 7×10-3 Pa.

In a fourth possible implementation manner of the third aspect, when diffusion-bonding is performed between the aluminum alloy frame in which the graphite sheet is placed and the two aluminum alloy sheets, a temperature inside the furnace chamber is increased to 530 degrees Celsius to 590 degrees Celsius, and a pressure of 10 MPa to 15 MPa is applied to the laminated structure, so that diffusion-bonding is performed between surfaces of the graphite sheet and aluminum alloys that are in contact with each other.

In a fifth possible implementation manner of the third aspect, there are multiple openings inside the aluminum alloy frame, there are also more graphite sheets, and each graphite sheet is correspondingly accommodated inside one opening.

According to a fourth aspect, a method for making a thermally conductive composite sheet is provided, where the method for making a thermally conductive composite sheet includes the following steps: providing two aluminum alloy sheets with a thickness of 0.26 millimeters to 1.0 millimeters and an aluminum alloy frame, and performing mechanical treatment and chemical treatment on the aluminum alloy sheets and the aluminum alloy frame, so as to decrease roughness of surfaces of the aluminum alloy sheets and an aluminum alloy surface, and obtain active aluminum alloy surfaces; providing a graphite sheet and two transition sheets; separately placing the two transition sheets on two opposite sides of the graphite sheet, so that diffusion-bonding is performed on the graphite sheet and the transition sheets to obtain a composite layer; placing the composite layer in an opening of the aluminum alloy frame, separately placing the aluminum alloy sheets on two opposite sides of the aluminum alloy frame and the graphite sheet to form a laminated structure, placing the laminated structure in a furnace chamber, and performing vacuumization; and performing diffusion-bonding between the aluminum alloy frame in which the composite layer is placed and the two aluminum alloy sheets, so as to obtain a thermally conductive composite sheet.

In a first possible implementation manner of the fourth aspect, the mechanical treatment includes grinding and polishing, so as to decrease roughness of the surfaces of the aluminum alloy sheets and the aluminum alloy surface.

In a second possible implementation manner of the fourth aspect, the chemical treatment includes acid cleaning and alkaline cleaning, so as to obtain the active aluminum alloy surfaces.

In a third possible implementation manner of the fourth aspect, the furnace chamber is vacuumized until an intensity of pressure is 5×10-3 Pa to 7×10-3 Pa.

In a fourth possible implementation manner of the fourth aspect, when diffusion-bonding is performed between the aluminum alloy frame in which the composite layer is placed and the two aluminum alloy sheets, a temperature inside the furnace chamber is increased to 530 degrees Celsius to 590 degrees Celsius, and a pressure of 10 MPa to 15 MPa is applied to the laminated structure, so that diffusion-bonding is performed between surfaces of the graphite sheet and aluminum alloys that are in contact with each other.

In a fifth implementation manner of the fourth aspect, the two transition sheets are separately placed on the two opposite sides of the graphite sheet and are stacked in an aligned manner; the two transition sheets that are stacked and the graphite sheet are placed inside the furnace chamber; vacuumization is performed until an intensity of pressure is 5×10-3 Pa to 7×10-3 Pa; and then a furnace temperature is increased to 850 degrees Celsius to 830 degrees Celsius, and a pressure of 11 MPa to 12 MPa is applied between the two transition sheets, with duration of 100 minutes to 170 minutes.

According to the thermally conductive composite sheet and the method for making same that are provided in the present invention, both a graphite sheet and an aluminum alloy have a great heat conductivity, so that the thermally conductive composite sheet has a desirable heat-conducting property and a light weight, and can be widely applied to the field of thermal control technologies and the field of packaging technologies of electronic parts and components. After surfaces of the aluminum alloy sheet and the graphite sheet that are in contact with each other undergo mechanical treatment and chemical treatment, an aluminum oxide layer can be effectively removed from analuminum alloy surface and an active aluminum alloy surface is formed. A manner of performing diffusion-bonding under a vacuum condition is used to implement bonding between the aluminum alloy and the graphite sheet, which can implement seamless welding with high bonding quality. Therefore, problems such as bulging, deformation, and a thermal conduction failure do not occur even if the thermally conductive composite sheet is used in a complex and hostile environment. Further, the method for making the thermally conductive composite sheet provided in the present invention features a simple implementation manner, is applicable to mass production, and has a short production cycle, relatively low production costs, and relatively high production efficiency.

### BRIEF DESCRIPTION OF DRAWINGS

To describe the technical solutions in the embodiments of the present invention more clearly, the following briefly introduces the accompanying drawings required for describing the embodiments. Apparently, the accompanying drawings in the following description show merely some embodiments of the present invention, and a person of ordinary skill in the art may still derive other drawings from these accompanying drawings without creative efforts.
FIG. 1 is a schematic sectional view of a thermally conductive composite sheet according to a first exemplary implementation manner of the present invention;
FIG. 2 is a schematic exploded view of the thermally conductive composite sheet in FIG. 1;
FIG. 3 is a schematic sectional view of a thermally conductive composite material according to a second exemplary implementation manner of the present invention;
FIG. 4 is a schematic exploded view of the thermally conductive composite sheet in FIG. 3;
FIG. 5 is a schematic sectional view of a thermally conductive composite sheet according to a third implementation manner of the present invention;
FIG. 6 is a schematic exploded view of the thermally conductive composite sheet in FIG. 5;
FIG. 7 is a picture, taken by using an electron microscope, of an area for bonding aluminum alloys in this technical solution;
FIG. 8 is a picture, taken by using an electron microscope, of an area in which graphite and an aluminum alloy are bonded in this technical solution;

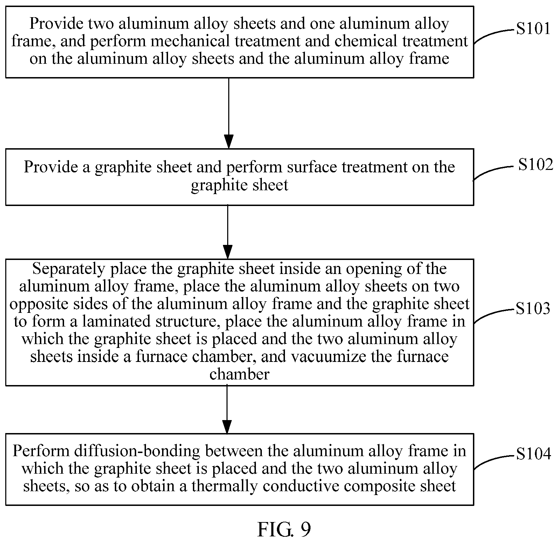

FIG. 9 is a flowchart of a method for making a thermally conductive composite sheet according to a first implementation manner of the present invention;
FIG. 10 is a flowchart of a method for making a thermally conductive composite sheet according to a second exemplary implementation manner of the present invention; and
FIG. 11 is a flowchart of a method for making a thermally conductive composite sheet according to a third exemplary implementation manner of the present invention.

### DESCRIPTION OF EMBODIMENTS

The following clearly and completely describes the technical solutions in the embodiments of the present invention with reference to the accompanying drawings in the embodiments of the present invention. Apparently, the described embodiments are merely some but not all of the embodiments of the present invention. All other embodiments obtained by a person of ordinary skill in the art based on the embodiments of the present invention without creative efforts shall fall within the protection scope of the present invention.

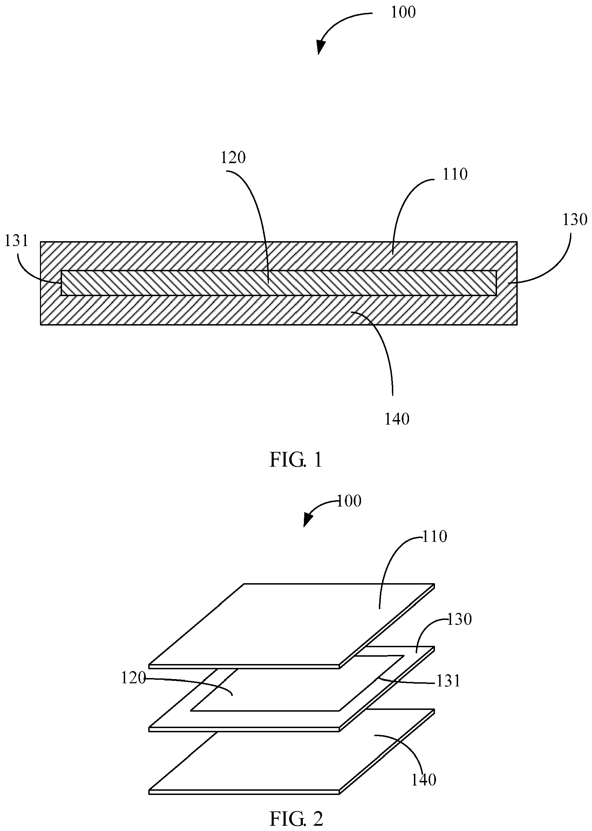

A first technical solution of the present invention provides a thermally conductive composite sheet. Referring to FIG. 1 and FIG. 2, a first implementation manner of this technical solution provides a thermally conductive composite sheet 100. The thermally conductive composite sheet 100 includes a first aluminum alloy layer 110, a graphite sheet 120, an aluminum alloy frame 130, and a second aluminum alloy layer 140. The aluminum alloy frame 130 is provided with an opening 131. The graphite sheet 120 is positioned inside the opening 131 of the aluminum alloy frame 130. The aluminum alloy frame 130 and the graphite sheet 120 are sandwiched between the first aluminum alloy layer 110 and the second aluminum alloy layer 140; the first aluminum alloy layer 110 is diffusion-bonded to the graphite sheet 120 and the aluminum alloy frame 130; the second aluminum alloy layer 140 is diffusion-bonded to the graphite sheet 120 and the aluminum alloy frame 130; and the graphite sheet 120 is cladded by the first aluminum alloy layer 110, the second aluminum alloy layer 140, and the aluminum alloy frame 130, to form a unity.

A thickness of the thermally conductive composite sheet 100 may be less than 1 millimeter. Thicknesses of the first aluminum alloy layer 110 and the second aluminum alloy layer 140 are 0.26 millimeters to 1.0 millimeters. The first aluminum alloy layer 110, the aluminum alloy frame 130, and the second aluminum alloy layer 140 may be made of a same material, and may be specifically made of 6xxx series aluminum alloys (LD series) or 1xxx series aluminum alloys. The aluminum alloy mainly includes aluminum, magnesium, silicon, and the like. The graphite sheet 120 is made of a highly thermally conductive graphite sheet. A heat conductivity of the graphite sheet 120 should be greater than 600 W/m.K. A shape of the opening 131 formed in the aluminum alloy frame 130 corresponds to a shape of the graphite sheet 120, so that the graphite sheet 120 may be fit-embedded inside the aluminum alloy frame 130. Preferably, a thickness of the aluminum alloy frame 130 is equal to a thickness of the graphite sheet 120. In this implementation manner, both the first aluminum alloy layer 110 and the second aluminum alloy layer 140 are rectangular; the aluminum alloy frame 130 is a rectangular frame; the opening is also rectangular; and an area of the graphite sheet 120 is less than an area of the first aluminum alloy layer 110 and an area of the second aluminum alloy layer 140. The area of the graphite sheet 120 is equal to an area of the opening 131.

In this implementation manner, the thermally conductive composite sheet 100 is planarly sheet-shaped. The thermally conductive composite sheet 100 is approximately rectangular. It may be understood that the thermally conductive composite sheet 100 may be made into another shape such as a circular shape and a polygon according to actual needs. Moreover, the thermally conductive composite material 100 may also be made into a curved sheet-shaped structure.

According to the thermally conductive composite sheet provided in this technical solution, surfaces of the first aluminum alloy layer 110 and the second aluminum alloy layer 140, and the graphite sheet 120 and the aluminum alloy frame 130 that are in contact with each other are bonded by means of diffusion-bonding, so that strength of bonding between an aluminum alloy and the graphite sheet is desirable. Moreover, both an aluminum alloy and graphite have a small density and a desirable heat-conducting property, so that the thermally conductive composite sheet 100 has a relatively light weight and a desirable heat-conducting property, may be used as a material for designing a thermal control structure, and can improve heat dissipation efficiency of an electronic part or component connected to the thermally conductive composite sheet 100.

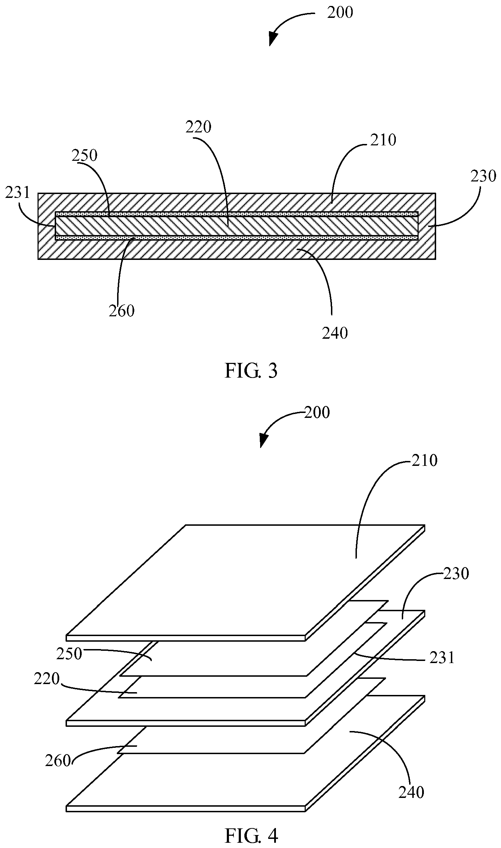

Referring to FIG. 3 and FIG. 4, a second exemplary implementation manner of the first technical solution in the present invention provides a thermally conductive composite sheet 200. The thermally conductive composite sheet 200 and the thermally conductive composite sheet 100 provided by the first exemplary implementation manner have similar structures and implement approximately the same functions. The thermally conductive composite sheet 200 includes a first aluminum alloy layer 210, a graphite sheet 220, an aluminum alloy frame 230, and a second aluminum alloy layer 240. The aluminum alloy frame 230 is provided with an opening 231. The graphite sheet 220 is positioned inside the opening 231 of the aluminum alloy frame 230. A difference lies in that the thermally conductive composite sheet 200 further includes a first transition layer 250 and a second transition layer 260. The first transition layer 250 is disposed between the graphite sheet 220 and the first aluminum alloy layer 210, and the second transition layer 260 is disposed between the graphite sheet 220 and the second aluminum alloy layer 240. The first aluminum alloy layer 210 and the first transition layer 250 are diffusion-bonded; the first transition layer 250 and the graphite sheet 220 are diffusion-bonded; the graphite sheet 120 and the second transition layer 260 are diffusion-bonded; and the second transition layer 260 and the second aluminum alloy layer 240 are diffusion-bonded. The first transition layer 250 and the second transition layer 260 have a same area as that of the graphite layer 220. Two opposite sides of the aluminum alloy frame 230 are separately diffusion-bonded to the first aluminum alloy layer 210 and the second aluminum alloy layer 240, so that the first transition layer 250, the second transition layer 260, and the graphite sheet 220 are cladded by the first aluminum alloy layer 210, the second aluminum alloy layer 240, and the aluminum alloy frame 230, to form a unity.

In this implementation manner, the thermally conductive composite sheet 200 is planarly sheet-shaped. The thermally conductive composite sheet 200 is approximately rectangular. It may be understood that the thermally conductive composite sheet 200 may be made into another shape such as a circular shape and a polygon according to actual needs. Moreover, the thermally conductive composite material 200 may also be made into a curved sheet-shaped structure.

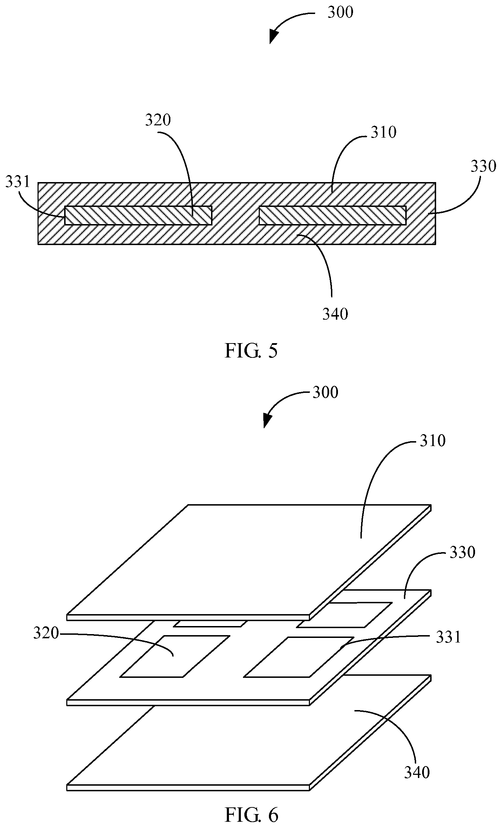

Referring to FIG. 5 and FIG. 6, a third implementation manner of the first technical solution in the present invention provides a thermally conductive composite sheet 300. The thermally conductive composite sheet 300 and the thermally conductive composite sheet 100 provided by the first exemplary implementation manner have similar structures and implement approximately the same functions. The thermally conductive composite sheet 300 includes a first aluminum alloy layer 310, a graphite sheet 320, an aluminum alloy frame 330, and a second aluminum alloy layer 340. A difference lies in that the thermally conductive composite sheet 300 includes multiple graphite sheets 320 and the aluminum alloy frame 330 is provided with multiple openings 331. Each graphite sheet 320 is correspondingly embedded inside one opening 331. The aluminum alloy frame 330 and the graphite sheets 320 are sandwiched between the first aluminum alloy layer 310 and the second aluminum alloy layer 340; the first aluminum alloy layer 310 is diffusion-bonded to the graphite sheets 320 and the aluminum alloy frame 330; the second aluminum alloy layer 340 is diffusion-bonded to the graphite sheets 320 and the aluminum alloy frame 330; and the multiple graphite sheets 320 are cladded by the first aluminum alloy layer 310, the second aluminum alloy layer 340, and the aluminum alloy frame 330, to form a unity. It may be understood that the thermally conductive composite sheet 300 in this implementation manner may further include a transition layer, where the transition layer is correspondingly disposed on two opposite sides of each graphite sheet 320.

This implementation manner may be used to make a thermally conductive composite sheet with a relatively large area.

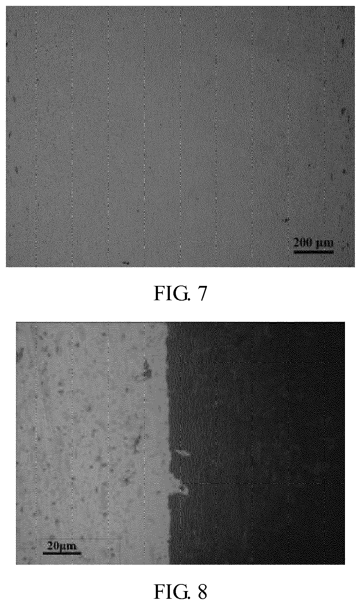

A second technical solution of the present invention provides a method for making a thermally conductive composite sheet. Referring to FIG. 7 and FIG. 2, a first exemplary implementation manner of the second technical solution in the present invention provides a method for making a thermally conductive composite sheet. A description is provided below by using an example of making the thermally conductive composite sheet 100 provided by the first exemplary implementation manner of the first technical solution. The method for making the thermally conductive composite sheet 100 includes the following steps:
Step S101: Provide two aluminum alloy sheets and one aluminum alloy frame, and perform mechanical treatment and chemical treatment on the aluminum alloy sheets and the aluminum alloy frame.

Thicknesses of the aluminum alloy sheets and the aluminum alloy frame are 0.26 millimeters to 1.0 millimeters. The aluminum alloy sheets and the aluminum alloy frame may be made of a same material, and may be specifically made of 6xxx series aluminum alloys (LD series) or 1xxx series aluminum alloys. A purpose of performing mechanical treatment and chemical treatment on the aluminum alloy sheets and the aluminum alloy frame is to remove, from surfaces of the aluminum alloy sheets and the aluminum alloy frame, an aluminum oxide layer formed due to oxidation, and obtain active aluminum alloy surfaces.

First, mechanical treatment is performed on the aluminum alloy sheets and the aluminum alloy frame. The mechanical treatment includes grinding and polishing, so as to decrease roughness of the surfaces of the aluminum alloy sheets and the aluminum alloy frame. Specifically, when grinding is performed, 400#, 600#, 1000#, and 2000# abrasive paper may be successively used to grind the surfaces of the aluminum alloy sheets and the aluminum alloy frame. Then, flannelette is used to polish the ground surfaces of the aluminum alloy sheets and the aluminum alloy frame.

After polishing treatment, the method may further include: immersing the aluminum alloy sheets and the aluminum alloy frame in acetone to remove greasy dirt and the like from the surfaces of the aluminum alloy sheets and the aluminum alloy frame. A time period of immersing the aluminum alloy sheets and the aluminum alloy frame in the acetone should be greater than 10 hours.

Then, chemical treatment is performed on the aluminum alloy sheets and the aluminum alloy frame. Chemical treatment includes alkaline cleaning and acid cleaning, so as to remove the aluminum oxide layer from the surfaces of the aluminum alloy sheets and the aluminum alloy frame, and obtain the active aluminum oxide surfaces. First, the aluminum alloy sheets and the aluminum alloy frame are immersed in an alkaline solution whose percentage mass content is 10%, such as a sodium hydroxide solution, and a temperature of the alkaline solution is kept at about 60 degrees Celsius. An immersing time period is about 5 minutes to 10 minutes. Then, the aluminum alloy sheets and the aluminum alloy frame are cleaned with flowing water. Then, the aluminum alloy sheets and the aluminum alloy frame are immersed in an acid solution whose percentage mass content is 25%, such as a nitric acid solution, with duration of 1 minute, where a temperature of the acid solution is kept at 18 degrees Celsius to 24 degrees Celsius.

After the treatment, the aluminum alloy sheets and the aluminum alloy frame are immersed in acetone and isolated from air, to prevent the surfaces of aluminum alloy sheets and the aluminum alloy frame from being oxidized.

Step S102: Provide a graphite sheet and perform surface treatment on the graphite sheet.

The performing surface treatment on the graphite sheet includes grinding and wiping a surface of the graphite sheet. Specifically, the surface of the graphite sheet is ground by using a 2000# abrasive paper or the like, and then the surface of the graphite sheet is wiped with acetone.

Step S103: Place the graphite sheet inside an opening of the aluminum alloy frame, separately place the aluminum alloy sheets on two opposite sides of the aluminum alloy frame and the graphite sheet to form a laminated structure, place the aluminum alloy frame in which the graphite sheet is placed and the two aluminum alloy sheets inside a furnace chamber, and vacuumize the furnace chamber. In this implementation manner, vacuumization is performed until an intensity of pressure inside the furnace chamber reaches 5×10-3 Pa to 7×10-3 Pa.

Step S104: Perform diffusion-bonding between the aluminum alloy frame in which the graphite sheet is placed and the two aluminum alloy sheets, so as to obtain the thermally conductive composite sheet 100.

After vacuumization, a temperature inside the furnace chamber is increased to 530 degrees Celsius to 590 degrees Celsius, and a pressure of 10 MPa to 15 MPa is applied to the laminated structure, so that diffusion-bonding is performed between surfaces of the graphite sheet and aluminum alloys that are in contact with each other. After mechanical treatment and chemical treatment, the surfaces of the aluminum alloy sheets and the aluminum alloy frame all become active aluminum alloy surfaces. Therefore, in a heated and pressurized state, carbon atoms and aluminum atoms between the active aluminum alloy surfaces and between the active aluminum alloy surfaces and the surface of the graphite sheet diffuse into each other, so as to form stable and reliable bonding.

Referring to both FIG. 7 and FIG. 8, after diffusion-bonding, bonding surfaces of the aluminum alloy sheets and the graphite sheet are tightly bonded. Bonding surfaces of the aluminum alloy sheets and the aluminum alloy frame form a unity after diffusion-bonding. The bonding surfaces of the aluminum alloy sheets and the aluminum alloy frame that are bonded to each other cannot be discerned even in a picture taken by using an electron microscope.

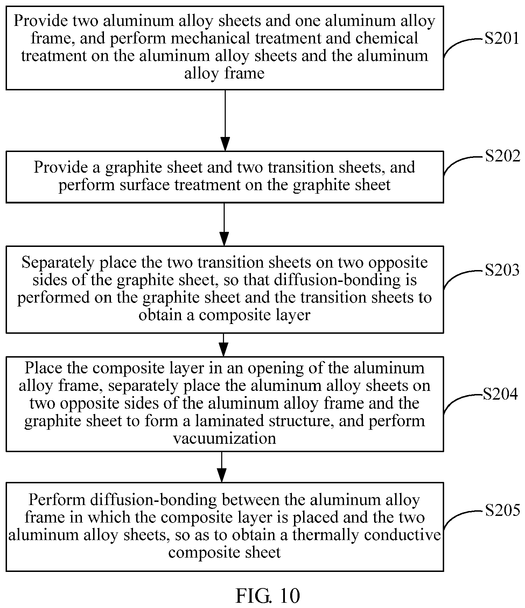

Referring to FIG. 10 and FIG. 4, a second exemplary implementation manner of the second technical solution in the present invention provides a method for making a thermally conductive composite sheet. A description is provided below by using an example of making the thermally conductive composite sheet 200 provided by the second exemplary implementation manner of the first technical solution. The method for making the thermally conductive composite sheet 200 includes the following steps:
Step S201: Provide two aluminum alloy sheets and an aluminum alloy frame, and perform mechanical treatment and chemical treatment on the aluminum alloy sheets and the aluminum alloy frame.

Both the aluminum alloy sheets and the aluminum alloy frame are the same as the aluminum alloy sheets and the aluminum alloy frame provided in the previous implementation manner. Moreover, mechanical treatment and chemical treatment on the aluminum alloy sheets and the aluminum alloy frame are also the same as those in the previous implementation manner.

Step S202: Provide a graphite sheet and two transition sheets, and perform surface treatment on the graphite sheet.

In this step, a treatment manner for the graphite sheet is the same as the treatment manner in step S102 in the first implementation manner, and is not described herein again.

The transition sheets may be made of titanium or an alloy including titanium. A shape of the transition sheet may be the same as a shape of the graphite sheet. A size of the transition sheet is also the same as a size of the graphite sheet. The transition sheets may also be made of other transition metals. A thickness of the transition sheet is 20 micrometers to 40 micrometers.

Step S203: Separately place the two transition sheets on two opposite sides of the graphite sheet, so that diffusion-bonding is performed on the graphite sheet and the transition sheets to obtain a composite layer.

The two transition sheets are separately placed on the two opposite sides of the graphite sheet and are stacked in an aligned manner, so that the transition sheets and the graphite sheet completely overlap. The two transition sheets that are stacked and the graphite sheet are placed inside a furnace chamber, and vacuumization is performed until an intensity of pressure is 5×10-3 Pa to 7×10-3 Pa. Then a furnace temperature is increased to 850 degrees Celsius to 930 degrees Celsius and a pressure of 11 MPa to 12 MPa is applied between the two transition sheets, with duration of 100 minutes to 170 minutes, so that atoms of surfaces of the transition sheets and the graphite sheet that are in contact with each other fully diffuse.

Step S204: Place the composite layer in an opening of the aluminum alloy frame, place the aluminum alloy sheets on two opposite sides of the aluminum alloy frame and the graphite sheet to form a laminated structure, and perform vacuumization.

The aluminum alloy frame in which the graphite sheet is placed and the two aluminum alloy sheet are placed in the furnace chamber, and vacuumization is performed inside the furnace chamber until the intensity of pressure reaches 5×10-3 Pa to 7×10-3 Pa.

Step S205: Perform diffusion-bonding between the aluminum alloy frame in which the composite layer is placed and the two aluminum alloy sheets, so as to obtain the thermally conductive composite sheet 100.

After vacuumization, the temperature inside the furnace chamber is increased to 530 degrees Celsius to 590 degrees Celsius, and a pressure of 10 MPa to 15 MPa is applied to the laminated structure, so that diffusion-bonding is performed between surfaces of the transition sheets and an aluminum alloy that are in contact with each other. After mechanical treatment and chemical treatment, the surfaces of the aluminum alloy sheets and the aluminum alloy frame all become active aluminum alloy surfaces. Therefore, in a heated and pressurized state, carbon atoms and aluminum atoms between the active aluminum alloy surfaces and between the active aluminum alloy surfaces and the surface of the graphite sheet diffuse into each other, so as to form stable and reliable bonding.

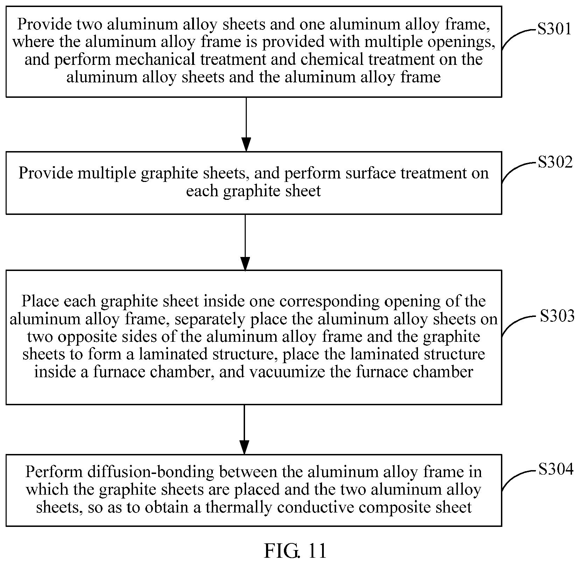

Referring to both FIG. 11 and FIG. 6, a third exemplary implementation manner of the second technical solution in the present invention provides a method for making a thermally conductive composite sheet. A description is provided below by using an example of making the thermally conductive composite sheet 300 provided by the third exemplary implementation manner of the first technical solution. The method for making the thermally conductive composite sheet 300 includes the following steps:
Step S301: Provide two aluminum alloy sheets and one aluminum alloy frame, where the aluminum alloy frame is provided with multiple openings, and perform mechanical treatment and chemical treatment on the aluminum alloy sheets and the aluminum alloy frame.

Thicknesses of the aluminum alloy sheets and the aluminum alloy frame are 0.26 millimeters to 1.0 millimeters. The aluminum alloy sheets and the aluminum alloy frame may be made of a same material, and may be specifically made of 6xxx series aluminum alloys (LD series) or 1xxx series aluminum alloys. A purpose of performing mechanical treatment and chemical treatment on the aluminum alloy sheets and the aluminum alloy frame is to remove, from surfaces of the aluminum alloy sheets and the aluminum alloy frame, an aluminum oxide layer formed due to oxidation, and obtain active aluminum alloy surfaces. The multiple openings are formed inside the aluminum alloy frame. In this implementation manner, the multiple openings are arranged in an array. Shapes and sizes of the multiple openings are all the same.

In this step, mechanical treatment and chemical treatment on the aluminum alloy sheets and the aluminum alloy frame are also the same as those in step S101 in the first implementation manner, and are not described herein again.

Step S302: Provide multiple graphite sheets, and perform surface treatment on each graphite sheet.

A shape and a size of each graphite sheet correspond to the shape and the size of the opening formed inside the aluminum alloy frame.

In this step, a treatment manner for the graphite sheets is the same as that in step S102 in the first implementation manner, and is not described herein again.

Step S303: Place each graphite sheet inside one corresponding opening of the aluminum alloy frame, place the aluminum alloy sheets on two opposite sides of the aluminum alloy frame and the graphite sheets to form a laminated structure, place the laminated structure inside a furnace chamber, and vacuumize the furnace chamber. In this implementation manner, vacuumization is performed until an intensity of pressure inside the furnace chamber reaches 5×10-3 Pa to 7×10-3 Pa.

Step S304: Perform diffusion-bonding between the aluminum alloy frame in which the graphite sheets are placed and the two aluminum alloy sheets, so as to obtain the thermally conductive composite sheet 300.

After vacuumization, a temperature inside the furnace chamber is increased to 530 degrees Celsius to 590 degrees Celsius, and a pressure of 10 MPa to 15 MPa is applied to the laminated structure, so that diffusion-bonding is performed between surfaces of the graphite sheets and an aluminum alloy that are in contact with each other. After mechanical treatment and chemical treatment, the surfaces of the aluminum alloy sheets and the aluminum alloy frame all become active aluminum alloy surfaces. Therefore, in a heated and pressurized state, carbon atoms and aluminum atoms between the active aluminum alloy surfaces and between the active aluminum alloy surfaces and the surface of the graphite sheets diffuse into each other, so as to form stable and reliable bonding.

According to the thermally conductive composite sheet and the method for making same that are provided in the present invention, both a graphite sheet and an aluminum alloy have a great heat conductivity, so that the thermally conductive composite sheet has a desirable heat-conducting property and a light weight, and can be widely applied to the field of thermal control technologies and the field of packaging technologies of electronic parts and components. After surfaces of the aluminum alloy sheet and the graphite sheet that are in contact with each other undergo mechanical treatment and chemical treatment, an aluminum oxide layer can be effectively removed from an aluminum alloy surface and an active aluminum alloy surface is formed. A manner of performing diffusion-bonding under a vacuum condition is used to implement bonding between the aluminum alloy and the graphite sheet, which can implement seamless welding with high bonding quality. Therefore, problems such as bulging, deformation, and a thermal conduction failure do not occur even if the thermally conductive composite sheet is used in a complex and hostile environment. Further, the method for making the thermally conductive composite sheet provided in the present invention features a simple implementation manner, is applicable to mass production, and has a short production cycle, relatively low production costs, and relatively high production efficiency.

## Claims

1. A thermally conductive composite sheet, comprising a first aluminum alloy layer (110, 210, 310), at least one graphite sheet (120, 220, 320), an aluminum alloy frame (130, 230, 330), and a second aluminum alloy layer (140, 240, 340), wherein the aluminum alloy frame (130, 230, 330) is provided with at least one opening; the graphite sheet (120, 220, 320) is positioned inside the opening of the aluminum alloy frame (130, 230, 330); the aluminum alloy frame (130, 230, 330) and the graphite sheet (120, 220, 320) are sandwiched between the first aluminum alloy layer (110, 210, 310) and the second aluminum alloy layer (140, 240, 340); the first aluminum alloy layer (110, 210, 310) is diffusion-bonded to the graphite sheet (120, 220, 320) and the aluminum alloy frame (130, 230, 330); the second aluminum alloy layer (140, 240, 340) is diffusion-bonded to the graphite sheet (120, 220, 320) and the aluminum alloy frame (130, 230, 330); and the graphite sheet (120, 220, 320) is cladded by the first aluminum alloy layer (110, 210, 310), the second aluminum alloy layer (140, 240, 340), and the aluminum alloy frame (130, 230, 330), to form a unity;
**characterized in that**,
a thickness of the first aluminum alloy layer (110, 210, 310) is 0.26 millimeters to 1.0 millimeters, and wherein a thickness of the second aluminum alloy layer (140, 240, 340) is 0.26 millimeters to 1.0 millimeters.

2. The thermally conductive composite sheet according to claim 1, wherein materials of the first aluminum alloy layer (110, 210, 310), the second aluminum alloy layer (140, 240, 340), and the aluminum alloy frame (130, 230, 330) are the same.

3. The thermally conductive composite sheet according to claim 1, wherein there is one opening inside the aluminum alloy frame (130, 230, 330), there is also one graphite sheet (120, 220, 320), and the graphite sheet (120, 220, 320) is accommodated inside the opening.

4. The thermally conductive composite sheet according to claim 1, wherein there are multiple openings inside the aluminum alloy frame (130, 230, 330), there are also multiple graphite sheets (120, 220, 320), and each graphite sheet (120, 220, 320) is correspondingly accommodated inside one opening.

5. The thermally conductive composite sheet according to claim 1, further comprising a first transition layer (250), a second transition layer (260), wherein the first transition layer (250) is disposed between the graphite sheet (120, 220, 320) and the first aluminum alloy layer (110, 210, 310); the second transition layer (260) is disposed between the second aluminum alloy layer (140, 240, 340) and the graphite sheet (120, 220, 320); the first aluminum alloy layer (110, 210, 310) and the first transition layer (250) are diffusion-bonded; the graphite sheet (120, 220, 320) and the second transition layer (260) are diffusion-bonded; the second transition layer (260) and the second aluminum alloy layer (140, 240, 340) are diffusion-bonded; and two opposite sides of the aluminum alloy frame (130, 230, 330) are separately diffusion-bonded to the first aluminum alloy layer (110, 210, 310) and the second aluminum alloy layer (140, 240, 340), so that the first transition layer (250), the second transition layer (260), and the graphite sheet (120, 220, 320) are cladded by the first aluminum alloy layer (110, 210, 310), the second aluminum alloy layer (140, 240, 340), and the aluminum alloy frame (130, 230, 330), to form a unity.

6. The thermally conductive composite sheet according to claim 1, wherein the first transition layer (250) is made of titanium or an alloy comprising titanium.

7. The thermally conductive composite sheet according to claim 1, wherein the second transition layer (260) is made of titanium or an alloy comprising titanium.

8. The thermally conductive composite sheet according to claim 1, wherein a thickness of the first transition layer (250) is 20 micrometers to 40 micrometers.

9. The thermally conductive composite sheet according to claim 1, wherein a thickness of the second transition layer (260) is 20 micrometers to 40 micrometers.

10. A method for making a thermally conductive composite sheet, comprising the following steps:
providing two aluminum alloy sheets (110, 210, 310, 140, 240, 340) with a thickness of 0.26 millimeters to 1.0 millimeters and one aluminum alloy frame (130, 230, 330), wherein the aluminum alloy frame (130, 230, 330) is provided with at least one opening, and performing mechanical treatment and chemical treatment on the aluminum alloy sheets (110, 210, 310, 140, 240, 340) and the aluminum alloy frame (130, 230, 330), so as to decrease roughness of surfaces of the aluminum alloy sheets (110, 210, 310, 140, 240, 340) and a surface of the aluminum alloy frame (130, 230, 330), and obtain active aluminum alloy surfaces;
providing at least one graphite sheet (120, 220, 320);
placing the graphite sheet (120, 220, 320) inside the opening of the aluminum alloy frame (130, 230, 330), separately placing the aluminum alloy sheets (110, 210, 310, 140, 240, 340) on two opposite sides of the aluminum alloy frame (130, 230, 330) and the graphite sheet (120, 220, 320) to form a laminated structure, placing the laminated structure inside a furnace chamber, and vacuumizing the furnace chamber; and
heating and pressurizing the laminated structure, and performing diffusion-bonding between the aluminum alloy frame (130, 230, 330) in which the graphite sheet (120, 220, 320) is placed and the two aluminum alloy sheets (110, 210, 310, 140, 240, 340), so as to obtain a thermally conductive composite sheet.

11. The method for making a thermally conductive composite sheet according to claim 10, wherein the mechanical treatment comprises grinding and polishing, so as to decrease roughness of the surfaces of the aluminum alloy sheets (110, 210, 310, 140, 240, 340) and the surface of the aluminum alloy frame (130, 230, 330).

12. The method for making a thermally conductive composite sheet according to claim 10, wherein the chemical treatment comprises acid cleaning and alkaline cleaning, so as to obtain the active aluminum alloy surfaces.

13. The method for making a thermally conductive composite sheet according to claim 10, wherein the furnace chamber is vacuumized until an intensity of pressure is 5×10-3 Pa to 7×10-3 Pa.

14. The method for making a thermally conductive composite sheet according to claim 10, wherein when diffusion-bonding is performed between the aluminum alloy frame (130, 230, 330) in which the graphite sheet (120, 220, 320) is placed and the two aluminum alloy sheets (110, 210, 310, 140, 240, 340), a temperature inside the furnace chamber is increased to 530 degrees Celsius to 590 degrees Celsius, and a pressure of 10 MPa to 15 MPa is applied to the laminated structure, so that diffusion-bonding is performed between surfaces of the graphite sheet (120, 220, 320) and the aluminum alloy sheets (110, 210, 310, 140, 240, 340) that are in contact with each other.

15. The method for making a thermally conductive composite sheet according to claim 10, wherein there are multiple openings inside the aluminum alloy frame (130, 230, 330), there are also multiple graphite sheets (120, 220, 320), and each graphite sheet (120, 220, 320) is correspondingly accommodated inside one opening.

16. The method for making a thermally conductive composite sheet according to claim 10, further comprising the following steps:
providing two transition sheets;
separately placing the two transition sheets on two opposite sides of the graphite sheet (120, 220, 320), so that diffusion-bonding is performed on the graphite sheet (120, 220, 320) and the transition sheets to obtain a composite layer;
placing the composite layer in an opening of the aluminum alloy frame (130, 230, 330), separately placing the aluminum alloy sheets (110, 210, 310, 140, 240, 340) on two opposite sides of the aluminum alloy frame (130, 230, 330) and the graphite sheet (120, 220, 320) to form a laminated structure, placing the laminated structure in a furnace chamber, and performing vacuumization; and
performing diffusion-bonding between the aluminum alloy frame (130, 230, 330) in which the composite layer is placed and the two aluminum alloy sheets (110, 210, 310, 140, 240, 340), so as to obtain a thermally conductive composite sheet.

17. The method for making a thermally conductive composite sheet according to claim 16, wherein the two transition sheets are separately placed on the two opposite sides of the graphite sheet (120, 220, 320); the two transition sheets and the graphite sheet (120, 220, 320) are stacked in an aligned manner; the two transition sheets that are stacked and the graphite sheet (120, 220, 320) are placed inside the furnace chamber; vacuumization is performed until an intensity of pressure is 5×10-3 Pa to 7×10-3 Pa; and then a furnace temperature is increased to 850 degrees Celsius to 930 degrees Celsius, and a pressure of 11 MPa to 12 MPa is applied between the two transition sheets, with duration of 100 minutes to 170 minutes.

## Patentansprüche

1. Wärmeleitfähiges Verbundmaterialblech, umfassend eine erste Aluminiumlegierungsschicht (110, 210, 310), wenigstens eine Graphitlage (120, 220, 320), einen Aluminiumlegierungsrahmen (130, 230, 330) und eine zweite Aluminiumlegierungsschicht (140, 240, 340), wobei der Aluminiumlegierungsrahmen (130, 230, 330) mit wenigstens einer Öffnung versehen ist; die Graphitlage (120, 220, 320) in der Öffnung des Aluminiumlegierungsrahmens (130, 230, 330) angeordnet ist; der Aluminiumlegierungsrahmen (130, 230, 330) und die Graphitlage (120, 220, 320) zwischen der ersten Aluminiumlegierungsschicht (110, 210, 310) und der zweiten Aluminiumlegierungsschicht (140, 240, 340) angeordnet sind; die erste Aluminiumlegierungsschicht (110, 210, 310) an die Graphitlage (120, 220, 320) und den Aluminiumlegierungsrahmen (130, 230, 330) diffusionsgebunden ist; die zweite Aluminiumlegierungsschicht (140, 240, 340) an die Graphitlage (120, 220, 320) und den Aluminiumlegierungsrahmen (130, 230, 330) diffusionsgebunden ist; und die Graphitlage (120, 220, 320) von der ersten Aluminiumlegierungsschicht (110, 210, 310), der zweiten Aluminiumlegierungsschicht (140, 240, 340) und dem Aluminiumlegierungsrahmen (130, 230, 330) ummantelt ist, um eine Einheit zu bilden;
**dadurch gekennzeichnet, dass**
die Dicke der ersten Aluminiumlegierungsschicht (110, 210, 310) 0,26 Millimeter bis 1,0 Millimeter beträgt und wobei die Dicke der zweiten Aluminiumlegierungsschicht (140, 240, 340) 0,26 Millimeter bis 1,0 Millimeter beträgt.

2. Wärmeleitfähiges Verbundmaterialblech gemäß Anspruch 1, wobei die Materialien der ersten Aluminiumlegierungsschicht (110, 210, 310), der zweiten Aluminiumlegierungsschicht (140, 240, 340) und des Aluminiumlegierungsrahmens (130, 230, 330) das gleiche sind.

3. Wärmeleitfähiges Verbundmaterialblech gemäß Anspruch 1, wobei eine Öffnung in dem Aluminiumlegierungsrahmen (130, 230, 330) vorliegt, ferner eine Graphitlage (120, 220, 320) vorliegt und die Graphitlage (120, 220, 320) in der Öffnung angeordnet ist.

4. Wärmeleitfähiges Verbundmaterialblech gemäß Anspruch 1, wobei mehrere Öffnungen in dem Aluminiumlegierungsrahmen (130, 230, 330) vorliegen, ferner mehrere Graphitlagen (120, 220, 320) vorliegen und jede Graphitlage (120, 220, 320) entsprechend in einer Öffnung angeordnet ist.

5. Wärmeleitfähiges Verbundmaterialblech gemäß Anspruch 1, ferner umfassend eine erste Übergangsschicht (250), eine zweite Übergangsschicht (260), wobei die erste Übergangsschicht (250) zwischen der Graphitlage (120, 220, 320) und der ersten Aluminiumlegierungsschicht (110, 210, 310) angeordnet ist; die zweite Übergangsschicht (260) zwischen der zweiten Aluminiumlegierungsschicht (140, 240, 340) und der Graphitlage (120, 220, 320) angeordnet ist; die erste Aluminiumlegierungsschicht (110, 210, 310) und die erste Übergangsschicht (250) diffusionsgebunden sind; die Graphitlage (120, 220, 320) und die zweite Übergangs schicht (260) diffusionsgebunden sind; die zweite Übergangs schicht (260) und die zweite Aluminiumlegierungsschicht (140, 240, 340) diffusionsgebunden sind; und zwei gegenüberliegende Seiten des Aluminiumlegierungsrahmens (130, 230, 330) getrennt an die erste Aluminiumlegierungsschicht (110, 210, 310) und die zweite Aluminiumlegierungsschicht (140, 240, 340) diffusionsgebunden sind, so dass die erste Übergangsschicht (250), die zweite Übergangsschicht (260) und die Graphitlage (120, 220, 320) von der ersten Aluminiumlegierungsschicht (110, 210, 310), der zweiten Aluminiumlegierungsschicht (140, 240, 340) und dem Aluminiumlegierungsrahmen (130, 230, 330) ummantelt sind, um eine Einheit zu bilden.

6. Wärmeleitfähiges Verbundmaterialblech gemäß Anspruch 1, wobei die erste Übergangs schicht (250) aus Titan oder einer Legierung, die Titan umfasst, besteht.

7. Wärmeleitfähiges Verbundmaterialblech gemäß Anspruch 1, wobei die zweite Übergangs schicht (260) aus Titan oder einer Legierung, die Titan umfasst, besteht.

8. Wärmeleitfähiges Verbundmaterialblech gemäß Anspruch 1, wobei die Dicke der ersten Übergangs schicht (250) 20 Mikrometer bis 40 Mikrometer beträgt.

9. Wärmeleitfähiges Verbundmaterialblech gemäß Anspruch 1, wobei die Dicke der zweiten Übergangs schicht (260) 20 Mikrometer bis 40 Mikrometer beträgt.

10. Verfahren zur Herstellung eines wärmeleitfähigen Verbundmaterialblechs, umfassend folgende Schritte:
Bereitstellen von zwei Aluminiumlegierungsblechen (110, 210, 310, 140, 240, 340) mit einer Dicke von 0,26 Millimeter bis 1,0 Millimeter und eines Aluminiumlegierungsrahmens (130, 230, 330), wobei der Aluminiumlegierungsrahmen (130, 230, 330) mit wenigstens einer Öffnung versehen ist, und Durchführen einer mechanischen Behandlung und chemischen Behandlung an den Aluminiumlegierungsblechen (110, 210, 310, 140, 240, 340) und dem Aluminiumlegierungsrahmen (130, 230, 330), um die Rauigkeit von Oberflächen der Aluminiumlegierungsbleche (110, 210, 310, 140, 240, 340) und einer Oberfläche des Aluminiumlegierungsrahmens (130, 230, 330) zu verringern und aktive Aluminiumlegierungsoberflächen zu erhalten;
Bereitstellen wenigstens einer Graphitlage (120, 220, 320);
Anordnen der Graphitlage (120, 220, 320) in der Öffnung des Aluminiumlegierungsrahmens (130, 230, 330), getrenntes Anordnen der Aluminiumlegierungsbleche (110, 210, 310, 140, 240, 340) an zwei gegenüberliegenden Seiten des Aluminiumlegierungsrahmens (130, 230, 330) und der Graphitlage (120, 220, 320), um eine laminierte Struktur zu bilden, Anordnen der laminierten Struktur in einer Ofenkammer und Evakuieren der Ofenkammer; und
Erhitzen und Druckbeaufschlagen der laminierten Struktur und Durchführen des Diffusionsbindens zwischen dem Aluminiumlegierungsrahmen (130, 230, 330), in dem die Graphitlage (120, 220, 320) angeordnet ist, und den beiden Aluminiumlegierungsblechen (110, 210, 310, 140, 240, 340), um ein wärmeleitfähiges Verbundmaterialblech zu erhalten.

11. Verfahren zur Herstellung eines wärmeleitfähigen Verbundmaterialblechs gemäß Anspruch 10, wobei die mechanische Behandlung Schleifen und Polieren umfasst, um die Rauigkeit der Oberflächen der Aluminiumlegierungsbleche (110, 210, 310, 140, 240, 340) und der Oberflächen des Aluminiumlegierungsrahmens (130, 230, 330) zu verringern.

12. Verfahren zur Herstellung eines wärmeleitfähigen Verbundmaterialblechs gemäß Anspruch 10, wobei die chemische Behandlung Säurereinigung und Alkalireinigung umfasst, um die aktiven Aluminiumlegierungsoberflächen zu erhalten.

13. Verfahren zur Herstellung eines wärmeleitfähigen Verbundmaterialblechs gemäß Anspruch 10, wobei die Ofenkammer evakuiert wird, bis die Höhe des Drucks 5 x 10-3 Pa bis 7 x 10-3 Pa beträgt.

14. Verfahren zur Herstellung eines wärmeleitfähigen Verbundmaterialblechs gemäß Anspruch 10, wobei, wenn das Diffusionsbinden zwischen dem Aluminiumlegierungsrahmen (130, 230, 330), in dem die Graphitlage (120, 220, 320) angeordnet ist, und den beiden Aluminiumlegierungsblechen (110, 210, 310, 140, 240, 340) durchgeführt wird, die Temperatur in dem Ofen auf 530 Grad Celsius bis 590 Grad Celsius erhöht wird und ein Druck von 10 MPa bis 15 MPa an die laminierte Struktur angelegt wird, so dass Diffusionsbinden zwischen Oberflächen der Graphitlage (120, 220, 320) und den Aluminiumlegierungsblechen (110, 210, 310, 140, 240, 340), die miteinander in Kontakt stehen, durchgeführt wird.

15. Verfahren zur Herstellung eines wärmeleitfähigen Verbundmaterialblechs gemäß Anspruch 10, wobei mehrere Öffnungen in dem Aluminiumlegierungsrahmen (130, 230, 330) vorliegen, ferner mehrere Graphitlagen (120, 220, 320) vorliegen und jede Graphitlage (120, 220, 320) entsprechend in einer Öffnung angeordnet wird.

16. Verfahren zur Herstellung eines wärmeleitfähigen Verbundmaterialblechs gemäß Anspruch 10, ferner umfassend folgende Schritte:
Bereitstellen von zwei Übergangsblechen;
getrenntes Anordnen der beiden Übergangsbleche an gegenüberliegenden Seiten der Graphitlage (120, 220, 320), so dass Diffusionsbinden an der Graphitlage (120, 220, 320) und den Übergangsblechen durchgeführt wird, um eine Verbundmaterialschicht zu bilden;
Anordnen der Verbundmaterialschicht in einer Öffnung des Aluminiumlegierungsrahmens (130, 230, 330), getrenntes Anordnen der Aluminiumlegierungsbleche (110, 210, 310, 140, 240, 340) an zwei gegenüberliegenden Seiten des Aluminiumlegierungsrahmens (130, 230, 330) und der Graphitlage (120, 220, 320), um eine laminierte Struktur zu bilden, Anordnen der laminierten Struktur in einer Ofenkammer und Durchführen von Evakuierung; und
Durchführen von Diffusionsbinden zwischen dem Aluminiumlegierungsrahmen (130, 230, 330), in dem die Verbundmaterialschicht angeordnet ist, und den beiden Aluminiumlegierungsblechen (110, 210, 310, 140, 240, 340), um ein wärmeleitfähiges Verbundmaterialblech zu erhalten.

17. Verfahren zur Herstellung eines wärmeleitfähigen Verbundmaterialblechs gemäß Anspruch 16, wobei die beiden Übergangsbleche getrennt an den beiden gegenüberliegenden Seiten der Graphitlage (120, 220, 320) angeordnet werden; die beiden Übergangsbleche und die Graphitlage (120, 220, 320) auf ausgerichtete Weise gestapelt werden; die beiden Übergangsbleche, die gestapelt sind, und die Graphitlage (120, 220, 320) in der Ofenkammer angeordnet werden; Vakuumisierung durchgeführt wird, bis die Höhe des Drucks 5 x 10-3 Pa bis 7 x 10-3 Pa beträgt; und dann die Ofentemperatur auf 850 Grad Celsius bis 930 Grad Celsius erhöht wird und ein Druck von 11 MPa bis 12 MPa mit einer Dauer von 100 Minuten bis 170 Minuten zwischen den beiden Übergangsblechen angelegt wird.

## Revendications

1. Tôle composite thermiquement conductrice, comprenant une première couche d'alliage d'aluminium (110, 210, 310), au moins une feuille de graphite (120, 220, 320), un cadre en alliage d'aluminium (130, 230, 330) et une seconde couche d'alliage d'aluminium (140, 240, 340), dans laquelle le cadre en alliage d'aluminium (130, 230, 330) est pourvu d'au moins une ouverture ; la feuille de graphite (120, 220, 320) est positionnée à l'intérieur de l'ouverture du cadre en alliage d'aluminium (130, 230, 330) ; le cadre en alliage d'aluminium (130, 230, 330) et la feuille de graphite (120, 220, 320) sont pris en sandwich entre la première couche d'alliage d'aluminium (110, 210, 310) et la seconde couche d'alliage d'aluminium (140, 240, 340); la première couche d'alliage d'aluminium (110, 210, 310) est soudée par diffusion à la feuille de graphite (120, 220, 320) et au cadre en alliage d'aluminium (130, 230, 330) ; la seconde couche d'alliage d'aluminium (140, 240, 340) est soudée par diffusion à la feuille de graphite (120, 220, 320) et au cadre en alliage d'aluminium (130, 230, 330) ; et la feuille de graphite (120, 220, 320) est recouverte de la première couche d'alliage d'aluminium (110, 210, 310), de la seconde couche d'alliage d'aluminium (140, 240, 340) et du cadre en alliage d'aluminium (130, 230, 330) pour former un ensemble unitaire ;
**caractérisée en ce que**
une épaisseur de la première couche d'alliage d'aluminium (110, 210, 310) est de 0,26 millimètre à 1,0 millimètre et dans laquelle une épaisseur de la seconde couche d'alliage d'aluminium (140, 240, 340) est de 0,26 millimètre à 1,0 millimètre.

2. Tôle composite thermiquement conductrice selon la revendication 1, dans laquelle les matériaux de la première couche d'alliage d'aluminium (110, 210, 310), de la seconde couche d'alliage d'aluminium (140, 240, 340) et du cadre en alliage d'aluminium (130, 230, 330) sont les mêmes.

3. Tôle composite thermiquement conductrice selon la revendication 1, dans laquelle il y a une ouverture à l'intérieur du cadre en alliage d'aluminium (130, 230, 330), il y a également une feuille de graphite (120, 220, 320) et la feuille de graphite (120, 220, 320) est logée à l'intérieur de l'ouverture.

4. Tôle composite thermiquement conductrice selon la revendication 1, dans laquelle il y a de multiples ouvertures à l'intérieur du cadre en alliage d'aluminium (130, 230, 330), il y a également de multiples feuilles de graphite (120, 220, 320) et chaque feuille de graphite (120, 220, 320) est logée de façon correspondante à l'intérieur d'une ouverture.

5. Tôle composite thermiquement conductrice selon la revendication 1, comprenant en outre une première couche de transition (250), une seconde couche de transition (260), dans laquelle la première couche de transition (250) est placée entre la feuille de graphite (120, 220, 320) et la première couche d'alliage d'aluminium (110, 210, 310) ; la seconde couche de transition (260) est placée entre la seconde couche d'alliage d'aluminium (140, 240, 340) et la feuille de graphite (120, 220, 320) ; la première couche d'alliage d'aluminium (110, 210, 310) et la première couche de transition (250) sont soudées par diffusion ; la feuille de graphite (120, 220, 320) et la seconde couche de transition (260) sont soudées par diffusion ; la seconde couche de transition (260) et la seconde couche d'alliage d'aluminium (140, 240, 340) sont soudées par diffusion ; et deux côtés opposés du cadre en alliage d'aluminium (130, 230, 330) sont séparément soudés par diffusion à la première couche d'alliage d'aluminium (110, 210, 310) et à la seconde couche d'alliage d'aluminium (140, 240, 340), de sorte que la première couche de transition (250), la seconde couche de transition (260) et la feuille de graphite (120, 220, 320) sont recouvertes de la première couche d'alliage d'aluminium (110, 210, 310), de la seconde couche d'alliage d'aluminium (140, 240, 340) et du cadre en alliage d'aluminium (130, 230, 330), pour former un ensemble unitaire.

6. Tôle composite thermiquement conductrice selon la revendication 1, dans laquelle la première couche de transition (250) est constituée de titane ou d'un alliage comprenant du titane.

7. Tôle composite thermiquement conductrice selon la revendication 1, dans laquelle la seconde couche de transition (260) est constituée de titane ou d'un alliage comprenant du titane.

8. Tôle composite thermiquement conductrice selon la revendication 1, dans laquelle une épaisseur de la première couche de transition (250) est de 20 micromètres à 40 micromètres.

9. Tôle composite thermiquement conductrice selon la revendication 1, dans laquelle une épaisseur de la seconde couche de transition (260) est de 20 micromètres à 40 micromètres.

10. Procédé pour la fabrication d'une tôle composite thermiquement conductrice, comprenant les étapes suivantes :
l'utilisation de deux tôles en alliage d'aluminium (110, 210, 310, 140, 240, 340) ayant une épaisseur de 0,26 millimètre à 1,0 millimètre et d'un cadre en alliage d'aluminium (130, 230, 330), le cadre en alliage d'aluminium (130, 230, 330) étant pourvu d'au moins une ouverture, et la mise en oeuvre d'un traitement mécanique et d'un traitement chimique sur les tôles en alliage d'aluminium (110, 210, 310, 140, 240, 340) et le cadre en alliage d'aluminium (130, 230, 330), de manière à diminuer la rugosité de surfaces des tôles en alliage d'aluminium (110, 210, 310, 140, 240, 340) et d'une surface du cadre en alliage d'aluminium (130, 230, 330) et obtenir des surfaces en alliage d'aluminium actif ;
l'utilisation d'au moins une feuille de graphite (120, 220, 320) ;
la disposition de la feuille de graphite (120, 220, 320) à l'intérieur de l'ouverture du cadre en alliage d'aluminium (130, 230, 330), la disposition de façon séparée des tôles en alliage d'aluminium (110, 210, 310, 140, 240, 340) sur deux côtés opposés du cadre en alliage d'aluminium (130, 230, 330) et de la feuille de graphite (120, 220, 320) pour former une structure stratifiée, la disposition de la structure stratifiée à l'intérieur d'une chambre de four et la mise sous vide de la chambre de four ; et
le chauffage et la compression de la structure stratifiée et la mise en oeuvre d'un soudage par diffusion entre le cadre en alliage d'aluminium (130, 230, 330) dans lequel la feuille de graphite (120, 220, 320) est disposée et les deux tôles en alliage d'aluminium (110, 210, 310, 140, 240, 340), de manière à obtenir une tôle composite thermiquement conductrice.

11. Procédé pour la fabrication d'une tôle composite thermiquement conductrice selon la revendication 10, dans lequel le traitement mécanique comprend un meulage et un polissage, de manière à diminuer la rugosité des surfaces des tôles en alliage d'aluminium (110, 210, 310, 140, 240, 340) et de la surface du cadre en alliage d'aluminium (130, 230, 330).

12. Procédé pour la fabrication d'une tôle composite thermiquement conductrice selon la revendication 10, dans lequel le traitement chimique comprend un nettoyage à l'acide et un nettoyage alcalin, de manière à obtenir les surfaces en alliage d'aluminium actif.

13. Procédé pour la fabrication d'une tôle composite thermiquement conductrice selon la revendication 10, dans lequel la chambre de four est mise sous vide jusqu'à un niveau de pression de 5 x 10⁻³ Pa à 7 x 10⁻³ Pa.

14. Procédé pour la fabrication d'une tôle composite thermiquement conductrice selon la revendication 10, dans lequel lorsqu'un soudage par diffusion est effectué entre le cadre en alliage d'aluminium (130, 230, 330) dans lequel la feuille de graphite (120, 220, 320) est disposée et les deux tôles en alliage d'aluminium (110, 210, 310, 140, 240, 340), une température à l'intérieur de la chambre de four est augmentée à 530 degrés Celsius à 590 degrés Celsius et une pression de 10 MPa à 15 MPa est appliquée sur la structure stratifiée, de sorte qu'un soudage par diffusion est effectué entre des surfaces de la feuille de graphite (120, 220, 320) et des tôles en alliage d'aluminium (110, 210, 310, 140, 240, 340) qui sont en contact les unes avec les autres.

15. Procédé pour la fabrication d'une tôle composite thermiquement conductrice selon la revendication 10, dans lequel il y a de multiples ouvertures à l'intérieur du cadre en alliage d'aluminium (130, 230, 330), il y a également de multiples feuilles de graphite (120, 220, 320) et chaque feuille de graphite (120, 220, 320) est logée de façon correspondante à l'intérieur d'une ouverture.

16. Procédé pour la fabrication d'une tôle composite thermiquement conductrice selon la revendication 10, comprenant en outre les étapes suivantes :
la fourniture de deux feuilles de transition ;
la disposition de façon séparée des deux feuilles de transition sur deux côtés opposés de la feuille de graphite (120, 220, 320), de sorte qu'un soudage par diffusion est effectué sur la feuille de graphite (120, 220, 320) et les feuilles de transition pour obtenir une couche composite ;
la disposition de la couche composite dans une ouverture du cadre en alliage d'aluminium (130, 230, 330), la disposition de façon séparée des tôles en alliage d'aluminium (110, 210, 310, 140, 240, 340) sur deux côtés opposés du cadre en alliage d'aluminium (130, 230, 330) et de la feuille de graphite (120, 220, 320) pour former une structure stratifiée, la disposition de la structure stratifiée dans une chambre de four et la mise en oeuvre d'une mise sous vide ; et
la mise en oeuvre d'un soudage par diffusion entre le cadre en alliage d'aluminium (130, 230, 330) dans lequel la couche composite est disposée et les deux tôles en alliage d'aluminium (110, 210, 310, 140, 240, 340), de manière à obtenir une tôle composite thermiquement conductrice.

17. Procédé pour la fabrication d'une tôle composite thermiquement conductrice selon la revendication 16, dans lequel les deux feuilles de transition sont disposées de façon séparée sur les deux côtés opposés de la feuille de graphite (120, 220, 320) ; les deux feuilles de transition et la feuille de graphite (120, 220, 320) sont empilées d'une manière alignée, les deux feuilles de transition qui sont empilées et la feuille de graphite (120, 220, 320) sont disposées à l'intérieur de la chambre de four ; une mise sous vide est effectuée jusqu'à un niveau de pression de 5 x 10⁻³ Pa à 7 x 10⁻³ Pa ; et ensuite une température de four est augmentée à 850 degrés Celsius à 930 degrés Celsius et une pression de 11 MPa à 12 MPa est appliquée entre les deux feuilles de transition, sur une durée de 100 minutes à 170 minutes.
